# EUROPÄISCHE PATENTSCHRIFT

(11) **EP 0 915 511 B1**
(45) Veröffentlichungstag und Bekanntmachung des Hinweises auf die Patenterteilung: **29.09.2004**
(21) Anmeldenummer: 98119530.8
(22) Anmeldetag: 15.10.1998
(51) Int. Cl.: H01L 23/34, G02F 1/01, G02F 1/313, G02B 6/12

(54) **Anordnung aus einer zu beheizenden Schicht auf einem Substrat**
Arrangement of a layer to be heated on a substrate
Dispositif comportant un substrat ayant une couche destinée a être chauffée

(30) Priorität: 31.10.1997 DE 19748303
(43) Veröffentlichungstag der Anmeldung: 12.05.1999
(73) Patentinhaber: Infineon Technologies AG, 81669 München (DE)
(72) Erfinder: März, Reinhard, Dr., 81477 München (DE); Dieckröger, Jens, 81673 München (DE)
(74) Vertreter: Müller, Wolfram Hubertus, Dipl.-Phys.

(56) Entgegenhaltungen:
- EP-A- 0 653 665
- DE-A- 4 424 717
- DE-A- 4 446 101
- PATENT ABSTRACTS OF JAPAN vol. 017, no. 320 (P-1558), 17. Juni 1993 (1993-06-17) -& JP 05 034525 A (NIPPON TELEGR & TELEPH CORP), 12. Februar 1993 (1993-02-12)
- PATENT ABSTRACTS OF JAPAN vol. 1997, no. 12, 25. Dezember 1997 (1997-12-25) -& JP 09 211240 A (NIPPON TELEGR &TELEPH CORP <NTT>), 15. August 1997 (1997-08-15) -& DATABASE WPI Week 199743 Derwent Publications Ltd., London, GB; AN 1997-461237 XP002125810
- SUGITA A ET AL: "BRIDGE-SUSPENDED SILICA-WAVEGUIDE THERMO-OPTIC PHASE SHIFTER AND ITS APPLICATION TO MACH-ZEHNDER TYPE OPTICAL SWITCH" TRANSACTIONS OF THE INSTITUTE OF ELECTRONICS, INFORMATION AND COMMUNICATION ENGINEERS OF JAPAN,JP,INST. OF ELECTRONICS & COMMUNIC. ENGINEERS OF JAPAN. TOKYO, Bd. E73, Nr. 1, Seite 105-108 XP000103975
- M.HOFFMANN, E.VOGES: "Thermo-optical digital switches on silicon" PROCEEDINGS OF THE 7TH EUROPEAN CONFERENCE ON INTEGRATED OPTICS (ECIO'95),1995, Seiten 403-406, XP002123267 Delft

## Beschreibung

Die Erfindung betrifft eine Anordnung aus einer zu beheizenden Schicht auf einem Substrat nach dem Oberbegriff des Anspruchs 1.

Anordnungen dieser Art sind beispielsweise in den japanischen Abstracts zu den japanischen Patentanmeldungen 03187583 und 08015170 beschrieben. Bei diesen Anordnungen ist ein Substratbereich unterhalb eines zu erwärmenden Bereichs einer auf dem Substrat angeordneten Schicht entfernt und durch ein Material ersetzt, das eine geringere Wärmeleitfähigkeit als das Substratmaterial aufweist.

Der Erfindung liegt die Aufgabe zugrunde, eine Anordnung der genannten Art bereitzustellen, die eine nur geringe Heizleistung zum Erwärmen der Schicht benötigt und trotzdem sehr stabil und fest ist.

Diese Aufgabe wird durch die im kennzeichnenden Teil des Anspruchs 1 angegebenen Merkmale gelöst.

Bevorzugte und vorteilhafte Ausgestaltungen der erfindungsgemäßen Anordnung sind in Unteransprüchen angebeben.

Die Erfindung wird in der nachfolgenden Beschreibung anhand der Figuren 4 und 5 beispielhaft näher erläutert. Die Figuren 1 bis 3c zeigen zur Erläuterung den technischen Hintergrund.

Es zeigen also:
- Figur 1: ausschnitthaft eine Draufsicht auf ein Substrat mit einer zu heizenden Schicht,
- Figur 2: einen vertikalen Schnitt durch das Beispiel nach Figur 1 längs der Schnittlinie I-I,
- Figuren 3a bis 3c: jeweils in stark vereinfachter Darstellung eine Draufsicht auf eine Wellenleiteranordnung, bei der das Beispiel nach den Figuren 1 und 2 angewendet ist,
- Figur 4: ausschnitthaft eine Draufsicht auf ein Ausführungsbeispiel der erfindungsgemäßen Anordnung,
- Figur 5: einen vertikalen Schnitt durch das Beispiel nach Figur 4 längs der Schnittlinie II-II,

Die Figuren sind schematisch und nicht maßstäblich.

Bei den in den Figuren dargestellten Anordnungen sind die Schicht aus dem Material der bestimmten Wärmeleitfähigkeit λ_{w1} mit 3, das Substrat aus dem Material der im Vergleich zum Material der Schicht 3 größeren Wärmeleitfähigkeit λ_{w2} mit 4, der Oberflächenabschnitt des Substrats 4, auf dem die Schicht 3 angeordnet ist, mit 4, die Einrichtung zum Erwärmen des begrenzten Bereichs der Schicht 3 mit 20, und der erwärmte Bereich mit 35 bezeichnet.

Die Schicht 3 besteht beispielsweise aus einer optischen Schicht, in der zumindest ein optischer Wellenleiter ausgebildet ist, der bereichsweise zu erwärmen ist, beispielsweise um eine Brechzahl des Wellenleiters zu verändern. Diese Brechzahl ist beispielsweise die im Vergleich zu einer Brechzahl der Schicht 3 höhere Brechzahl eines eines in der Schicht 3 ausgebildeten streifenförmigen Gebiets 11, das einen lichtführenden Kern des Wellenleiters bildet und diesen Wellenleiter definiert.

Zur Reduzierung der zum Erwärmen des den Wellenleiter 11, d.h dessen Gebiet relativ höherer Brechzahl bereichsweise umfassenden begrenzten Bereichs 35 der Schicht 3 erforderlichen Heizleistung ist im Substrat 4 eine an die Schicht 3 grenzende und derart ausgebildete isolierende Einrichtung 41 vorhanden, daß ein in bezug auf den Oberflächenabschnitt 40 des Substrats 4 vertikal unter dem erwärmten Bereich 35 der Schicht 3 befindlicher Bereich 42 im Substrat 4 vom übrigen Substrat 4 thermisch isoliert ist.

Vorzugsweise weist die isolierende Einrichtung 41 eine im Substrat 4 ausgebildete Aussparung 410 auf, die sich senkrecht in Richtung r2 zum Oberflächenabschnitt 40 des Substrats 4 durch das ganze Substrat 4 hindurch erstreckt, an die Schicht 3 grenzt, thermisch isolierendes Material enthält, das vertikal unter dem erwärmten Bereich 35 an die Schicht 3 grenzt und den thermisch vom übrigen Substrat 4 isolierten Bereich 42 enthält.

Das thermisch isolierende Material kann Luft oder ein anderes gasförmiges, flüssiges oder festes Material geringer Wärmeleitfähigkeit sein.

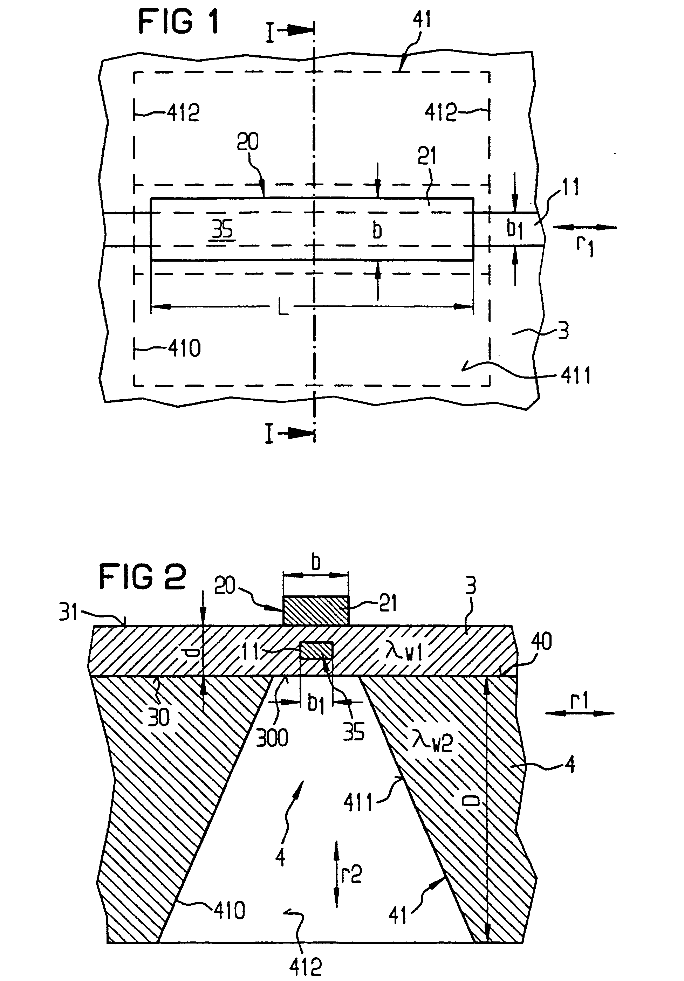

Beim Beispiel nach den Figuren 1 und 2 besteht die thermisch isolierende Einrichtung 41 aus der Aussparung 410 allein, deren Innenraum vollständig mit thermisch isolierendem Material ausgefüllt ist und die den vertikal unter dem erwärmten Bereich 35 der Schicht 3 befindliche Bereich 42 im Substrat 4 bildet.

Bei dieser Ausfürung weist die Einrichtung 20 zum Erwärmen eines begrenzten Bereichs 35 der Schicht 3 eine Heizelektrode 21 auf, die auf oder über der vom Oberflächenabschnitt 40 des Substrats 4 abgekehrten Oberfläche 31 der Schicht 3 angeordnet ist und einen Abschnitt des in der Schicht 3 ausgebildeten Wellenleiters 11 abdeckt. Beim Heizen der Elektrode 21 entsteht unter dieser Elektrode 21 der erwärmte Bereich 35, in welchem sich der von der Elektrode 21 abgedeckte Bereich des Wellenleiters 11 befindet.

Der Innenraum der Aussparung 410 ist durch in einem Winkel zum Oberflächenabschnitt 40 des Substrats 4 und der diesem Abschnitt 40 zugekehrten Oberfläche 30 der Schicht 3 angeordnete Begrenzungsflächen 411 und 412 des Substrats 4, die sich durch die ganze zum Oberflächenabschnitt 40 senkrechte Dicke D des Substrats 4 erstrecken, und durch einen vom Substrat 4 freien Bereich 300 der dem Oberflächenabschnitt 40 des Substrats 4 zugekehrten Oberfläche 30 der Schicht 3 begrenzt, über dem sich die Elektrode 21 befindet und der von den Begrenzungsflächen 411 und 412 umgeben und begrenzt ist.

Der vom Substrat 4 freie Bereich 300 der Oberfläche 30 der Schicht 3 kann flächenmäßig größer oder kleiner als die Elektrode 21 sein. Vorteilhaft kann es sein, wenn dieser Bereich 300 im wesentlichen die in Ausbreitungsrichtung r1 einer im Wellenleiter 11 parallel zum Oberflächenabschnitt 40 des Substrats 4 geführten optischen Welle gemessene Länge L und die parallel zu diesem Abschnitt 40 und senkrecht zur Ausbreitungsrichtung r1 gemessene Breite b der Elektrode 21 aufweist und mit der zum Oberflächenabschnitt 40 des Substrats 4 senkrechten Projektion der Elektrode 21 auf die Oberfläche 30 der Schicht 3 zusammenfällt und sich mit dieser Projektion deckt.

Bei einem konkreten Ausführungsbeispiel besteht die optische Schicht 3 aus Quarzglas und das Substrat 4 aus Silizium, das eine um etwa den Faktor 100 größere Wärmeleitfähigkeit als das Glas aufweist. Dieses Substrat 4 weist eine Dicke D von etwa 500 µm auf und ist erheblich größer als die beispielsweise weniger als 100 µm betragende Dicke d der Schicht 3.

Die Aussparung 410 kann in diesem Substrat 4 auf einfache Weise durch Naßätzen mit KOH erzeugt werden, weiches das Silizium, nicht aber das Glas ätzt. Dabei kann von der anisotropen Ätzeigenschaft des Siliziums Gebrauch gemacht werden, bei dem schräg in einem Winkel zum Oberflächenabschnitt 40 des Substrats 4 angeordnete geätzte Flächen entstehen. Die in der Ausbreitungsrichtung r1 sich erstreckenden Begrenzungsflächen 411 in den Figuren 1 und 2 sind solche Flächen. Dagegen stehen die Begrenzungsflächen 412 senkrecht zum Oberflächenabschnitt 40 und zur Ausbreitungsrichtung r1. Die schrägen Begrenzungsflächen 411 sind so zueinander angeordnet, daß sich die Aussparung 410 von der Schicht 3 nach unten in Richtung r2 senkrecht zum Oberflächenabschnitt 40 des Substrats 4 erweitert.

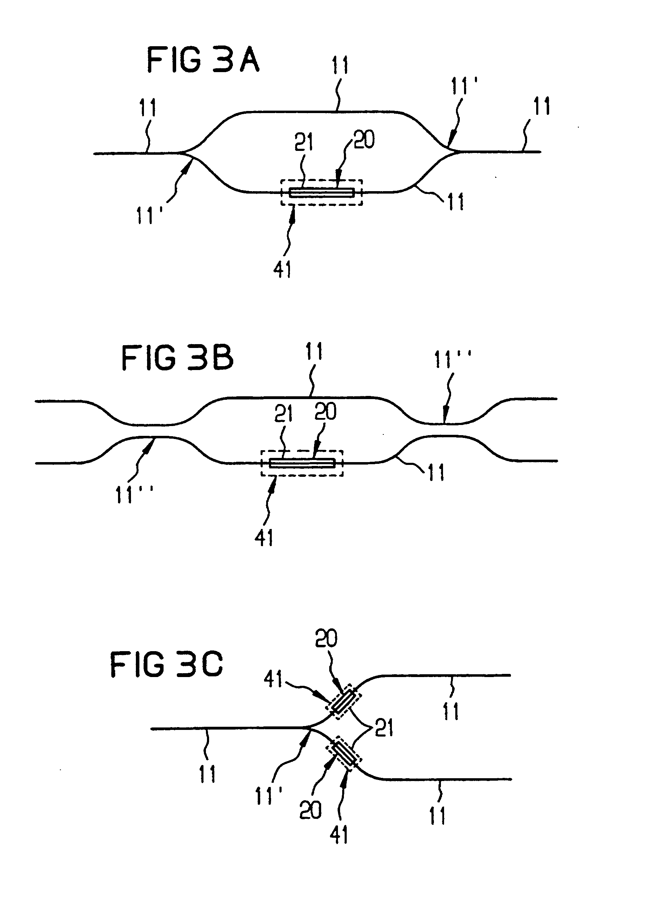

Die Figuren 3a bis 3c zeigen Anwendungsmöglichkeiten der Anordnung nach den Figuren 1 und 2, wobei von dieser Anordnung nur die Einrichtung 20 zum Erwärmen des begrenzten Bereichs 35 der Schicht 3 mit der Elektrode 21 und die Einrichtung 41 zum thermischen Isolieren des erwärmten Bereichs dargestellt sind.

In den Figuren 3a und 3b ist jeweils ein mit Wellenleitern 11 aufgebautes Mach-Zehnder-Interferometer dargestellt, bei dem zwei Wellenleiter 11 auseinander- und zusammengeführt sind und in einem dieser beiden Wellenleiter 11 eine Anordnung nach den Figuren 1 und 2 zur Veränderung der Brechzahl dieses einen Wellenleiters 11 angeordnet ist.

Beim Interferometer nach Figur 3a sind die beiden Wellenleiter 11 mit je einer Wellenleitergabel 11', beim Interferometer nach Figur 3b mit je einem optischen Koppler 11'', beispielsweise ein Richtkoppler, auseinander- und zusammengeführt. Das Interferometer nach Figur 3b kann als Mach-Zehnder-Koppler betrieben werden.

Die Figur 3c zeigt einen Schalter, bei dem zwei Wellenleiter 11 mit einer Wellenleitergabel 11' auseinander- und/oder zusammengeführt sind. In jedem dieser beiden Wellenleiter 11 ist je eine Anordnung nach den Figuren 1 und 2 zur Veränderung der Brechzahl dieses einen Wellenleiters 11 angeordnet. Dieser Schalter ist als digitaler Schalter betreibbar.

Bei der Anordnung nach den Figuren 1 und 2 weist die Elektrode 21 eine kleine Breite b auf, die nicht viel größer als die in der gleichen Richtung wie die Breite b gemessene Breite b1 des streifenförmigen Wellenleiters 11 ist. Dadurch kann auch der vom Substrat 4 freie Bereich 300 der dem Oberflächenabschnitt 40 des Substrats 4 zugekehrten Oberfläche 30 der Schicht 3 schmal sein und eine kleine Fläche aufweisen.

Es gibt jedoch beispielsweise optische Anordnungen, bei denen eine Elektrode 21 viele Wellenleiter 11 und einen großflächigen Bereich bedeckt, so daß auch der vom Substrat 4 freie Bereich 300 der dem Oberflächenabschnitt 40 des Substrats 4 zugekehrten Oberfläche 30 der Schicht 3 großflächig sein muß, wodurch sich wegen der kleinen Dicke d der Schicht 3 Stabilitäts- und Festigkeitsprobleme ergeben können.

Ein Beispiel für eine solche optische Anordnung ist eine optische Anordnung, die aus mehreren optischen Wellenleitern, deren jeder ein eingangsseitiges Ende zum Einkoppeln einer optischen Welle in diesen Wellenleiter, je ein ausgangsseitiges Ende zum Auskoppeln einer in diesem Wellenleitergeführten optischen Welle und zwischen den beiden Enden und eine bestimmte optische Länge aufweist, und aus einer Einrichtung zur Erzeugung einer Änderung der optischen Länge der Wellenleiter derart, daß die erzeugte Änderung der optischen Länge in einer Richtung von Wellenleiter zu Wellenleiter zunimmt, besteht.

Eine derartige Anordnung ist aus der EP-A-0 662 621 (GR 94 P 1013) bekannt. Bei dieser Anordnung weist jeder Wellenleiter 11 thermooptisches Material auf und die Einrichtung zur Erzeugung der in der einen Richtung von Wellenleiter zu Wellenleiter zunehmenden Änderung der optischen Länge der Wellenleiter dieser Anordnung weist eine Vielzahl Elektroden zum Erwärmen des thermooptischen Materials in jedem Wellenleiter 11 auf, deren jede je einen Bereich der Wellenleiter 11 abdeckt und erwärmt, wobei die abgedeckten Bereiche eine in der einen Richtung r von Wellenleiter 11 zu Wellenleiter zunehmende Breite aufweist. Diese bekannte Anordnung bildet ein steuerbares optisches Phased-Array zum räumlichen Trennen voneinander verschiedener optischer Wellenlängen.

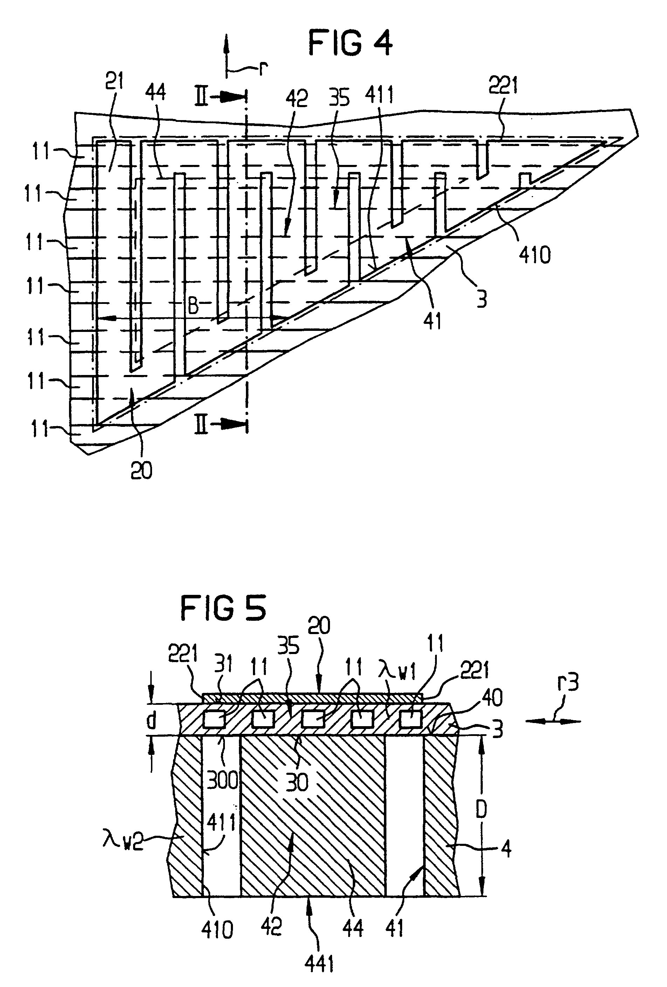

In den Figuren 4 und 5 ist eine derartige optische Anordnung dargestellt, bei der jeder der mehreren Wellenleiter 11 thermooptisches Material aufweist, die sich jedoch von der bekannten Anordnung darin unterscheidet, daß die Einrichtung 20 zur Erzeugung der in der einen Richtung r von Wellenleiter 11 zu Wellenleiter 11 zunehmenden Änderung der optischen Länge der Wellenleiter 11 eine einzige Elektrode 21 zum Erwärmen des thermooptischen Materials aufweist, die einen Bereich der Wellenleiter 11 mäanderförmig abdeckt und erwärmt, der eine in der einen Richtung r zunehmende Breite B aufweist. Dieser Bereich ist von der strichpunktierten und ein geschlossenes Dreieck beschreibenden Linie 221 umrandet.

Die Wellenleiter 11 sind beispielsweise parallel geradlinig und gleich lang zwischen den Enden 11₁ und 11₂ verlaufend dargestellt und die strichpunktierte Linie 221 in Figur 4 beschreibt beispielsweise ein Dreieck mit geraden Seiten. Bei konkreten Realisierungen einer solchen optischen Anordnung verlaufen diese Wellenleiter 11 wie bei der bekannten Anordnung gekrümmt und mit unterschiedlicher Krümmung, und die strichpunktierte Linie 221 beschreibt ein Dreieck mit krummlinigen Seiten.

Bei der Anordnung nach den Figuren 4 und 5 sind die mehreren Wellenleiter 11 in der Schicht 3 aus dem Material der bestimmten Wärmeleitfähigkeit λ_{w1} ausgebildet, die auf einem Oberflächenabschnitt 40 des Substrats 4 aus dem Material der im Vergleich zum Material der Schicht 3 größeren Wärmeleitfähigkeit λ_{w2} angeordnet ist.

Die thermisch isolierende Einrichtung 41 weist eine Aussparung 410 auf, die einen sich in Richtung r2 senkrecht zum Oberflächenabschnitt 40 des Substrats 4 erstreckenden Teil 44 des Substrats 4 in Richtung r3 parallel zum Oberflächenabschnitt 40 ringförmig geschlossen umgibt und vom übrigen Substrat 4 thermisch isoliert und zusammen mit dem thermisch isolierten Teil 44 des Substrats 4 den vertikal unter dem erwärmten Bereich 35 der Schicht 3 befindlichen thermisch isolierten Bereich 42 im Substrat 4 bildet.

Die Aussparung 410 weist eine den thermisch isolierten Bereich 42 im Substrat 4 geschlossen ringförmig umgebende Begrenzungsfläche 411 auf, die sich im wesentlichen senkrecht in Richtung r2 zum Oberflächenabschnitt 40 des Substrats 4 durch das ganze Substrat 4 hindurch bis zur Schicht 3 erstreckt und an die das Substrat 4 in Richtung r3 parallel zum Oberflächenabschnitt 40 von außen her angrenzt.

Die Begrenzungsfläche 411 der Aussparung 410 sollte vorteilhafterweise auf der dem Oberflächenabschnitt 40 des Substrats 4 zugekehrten Oberfläche 30 grenzenden Schicht 3 einen Bereich 300 umgrenzen, der mit der zum Oberflächenabschnitt 40 des Substrats 4 senkrechten Projektion des von der strichpunktierten Linie 221 umgrenzten Bereichs auf der vom Oberflächenabschnitt 40 abgekehrten Oberfläche 31 der Schicht 3 auf die dem Oberflächenabschnitt 40 zugekehrte Oberfläche 30 der Schicht 3 zusammenfällt und sich mit dieser Projektion deckt. D.h. die Begrenzungsfläche 411 der Aussparung 410 sollte auf der Oberflächer 30 der Schicht 3 eine Linie beschreiben, die mit der zum Oberflächenabschnitt 40 senkrechten Projektion der Linie 221 zusammenfällt. Dies ist hinsichtlich bestimmter optischer Eigenschaften der optischen Anordnung, die ein optisches Filter in Form eines Phased-Array sein kann, vorteilhaft. Dies gilt in gleicher Weise auch für die bekannte Anordnung in bezug auf eine gemeinsame umgrenzung der mehreren Elektroden.

Die Aussparung 410 kann zwischen der Begrenzungsfläche 411 und dem dem thermisch isolierten Teil 44 des Substrats 4 mit Luft oder einem anderen gasförmigen, flüssigen oder festen thermisch isolierenden Material geringer Wärmeleitfähigkeit gefüllt sein.

Beim Beispiel nach den Figuren 4 und 5 bildet die Aussparung 410 zusammen mit dem thermisch isolierten Teil 44 des Substrats 4 einen sich vertikal in Richtung r2 zum Oberflächenabschnitt 40 durch die ganze Dicke D des Substrat 4 bis zur Schicht 3 erstreckenden Graben, der den thermisch isolierten Teil 44 des Substrats 4 in Richtung r1 parallel zum Oberflächenabschnitt 40 des Substrats 4 geschlossen ringförmig umgibt und dadurch diesen Teil 44 vom übrigen Substrat 4 thermisch isoliert.

Beim Betrieb dieser Anordnung ist eine vom Oberflächenabschnitt 40 des Substrats 4 abgekehrte Oberfläche 441 des thermisch isolierten Teils 44 des Substrats 4 thermisch gegen die Umgebung thermisch zu isolieren, beispielsweise mittels Luft oder eines anderen gasförmigen, flüssigen oder festen thermisch isolierenden Materials geringer Wärmeleitfähigkeit.

Der thermisch isolierte Teil 44 des Substrats 4 bildet vorteilhafterweise eine die Stabilität und Festigkeit der Anordnung fördernde Stütze.

Bei einem konkreten Ausführungsbeispiel der Anordnung nach den Figuren 4 und 5 besteht die optische Schicht 3 aus Quarzglas und das Substrat 4 aus Silizium, das eine um etwa den Faktor 100 größere Wärmeleitfähigkeit als das Glas aufweist. Dieses Substrat 4 weist eine Dicke D von etwa 500 µm auf und ist erheblich größer als die beispielsweise weniger als 100 µm betragende Dicke d der Schicht 3. Die grabenförmige Aussparung 410 kann in diesem Substrat mit Hilfe eines Ultraschall-Schleifverfahrens und nachfolgendem Naßätzen mit KOH erzeugt werden.

Der thermisch isolierte Teil 44 des Substrats 4 vergrößert die Heizleistung etwas, da er miterwärmt werden muß, doch ist diese Vergrößerung im Vergleich zu einer Ausbildung einer Anordnung ohne solches Teil 44 in der Aussparung 410 nicht nennenswert.

Beim konkreten Ausführungsbeispiel mit der Schicht 3 aus Glas und dem Substrats 4 aus Silizium konnte vorteilhafterweise trotz des Vorhandenseins des thermisch isolierten Teils 44 im thermisch isolierten Bereich 42 eine Reduzierung der Heizleistung um 99% gegenüber einem gleich aufgebauten Beispiel ohne Aussparung 410 und thermisch isoliertem Bereich 42 im Substrat 4 erzielt werden.

## Patentansprüche

1. Anordnung aus
- einer Schicht (3) aus einem Material bestimmter Wärmeleitfähigkeit (λ_{w1}), die auf einem Oberflächenabschnitt (40) eines Substrats (4) aus einem Material einer im Vergleich zum Material der Schicht (3) größeren Wärmeleitfähigkeit (λ_{w2}) angeordnet ist, und
- einer Einrichtung (20) zum Erwärmen eines begrenzten Bereichs (35) der Schicht (3),
- wobei im Substrat (4) eine an die Schicht (3) grenzende und derart ausgebildete thermisch isolierende Einrichtung (41) vorhanden ist, daß ein in bezug auf den Oberflächenabschnitt (40) des Substrats (4) vertikal unter dem erwärmten Bereich (35) der Schicht (3) befindlicher Bereich (42) im Substrat (4) vom übrigen Substrat (4) thermisch isoliert ist, und
- wobei die thermisch isolierende Einrichtung (41) eine im Substrat (4) ausgebildete Aussparung (410) aufweist, die sich in Richtung (r2) senkrecht zum Oberflächenabschnitt (40) des Substrats (4) durch das ganze Substrat (4) hindurch erstreckt, an die Schicht (3) grenzt und thermisch isolierendes Material enthält, das vertikal an die Schicht (3) grenzt,
**dadurch gekennzeichnet, dass**
- die Aussparung (410) einen sich in Richtung (r2) senkrecht zum Oberflächenabschnitt (40) des Substrats (4) erstreckenden Teil (44) des Substrats (4) in Richtung (r3) parallel zum Oberflächenabschnitt (40) ringförmig geschlossen umgibt und vom übrigen Substrat (4) thermisch isoliert und zusammen mit dem thermisch isolierten Teil (44) des Substrats (4) den vertikal unter dem erwärmten Bereich (35) der Schicht (3) befindlichen thermisch isolierten Bereich (42) im Substrat (4) bildet.

2. Anordnung nach Anspruch 1, **dadurch gekennzeichnet, dass** die Schicht (3) aus SiO₂ besteht.

3. Anordnung nach Anspruch 1 oder 2 **dadurch gekennzeichnet, dass** das Substrat (4) aus Silizium besteht.

## Claims

1. Arrangement comprising
- a layer (3) made of a material having a specific thermal conductivity (λ_{w1}), which is arranged on a surface section (40) of a substrate (4) made of a material having a larger thermal conductivity (λ_{w2}) in comparison with the material of the layer (3), and
- a device (20) for heating a delimited region (35) of the layer (3),
- there being present in the substrate (4) a thermally insulating device (41) that adjoins the layer (3) and is formed in such a way that a region (42) in the substrate (4), which region is situated vertically below the heated region (35) of the layer (3) with respect to the surface section (40) of the substrate (4), is thermally insulated from the rest of the substrate (4), and
- the thermally insulating device (41) having a cutout (410), which is formed in the substrate (4), extends in the direction (r2) perpendicular to the surface section (40) of the substrate (4) through the entire substrate (4), adjoins the layer (3) and contains thermally insulating material that vertically adjoins the layer (3),
**characterized in that**
- the cutout (410) surrounds in annularly closed fashion a part (44) of the substrate (4) in the direction (r3) parallel to the surface section (40), the said part extending in the direction (r2) perpendicular to the surface section (40) of the substrate (4), and thermally insulates the said part from the rest of the substrate (4) and, together with the thermally insulated part (44) of the substrate (4) forms the thermally insulated region (42) in the substrate (4) that is situated vertically below the heated region (35) of the layer (3).

2. Arrangement according to Claim 1, **characterized in that** the layer (3) comprises SiO₂.

3. Arrangement according to Claim 1 or 2, **characterized in that** the substrate (4) comprises silicon.

## Revendications

1. Dispositif constitué
- d'une couche (3) en un matériau d'une certaine conductibilité (λ_{w1}) thermique, qui est disposée sur une partie (40) de surface d'un substrat (4) en un matériau ayant une conductibilité (λ_{w2}) thermique plus grande que celle du matériau de la couche (3), et
- d'un dispositif (20) pour chauffer une région (35) limitée de la couche (3),
- dans lequel il y a, dans le substrat (4), un dispositif (41) délimitant la couche (3) et isolant thermiquement, en étant constitué de façon à ce qu'une région (42) du substrat, se trouvant par rapport à la partie (40) de surface du substrat (4) verticalement sous la région (35) chauffée de la couche (3), soit isolée thermiquement du reste du substrat (4), et
- dans lequel le dispositif (41) isolant thermiquement a un évidement (410) constitué dans le substrat, qui s'étend dans une direction (r2) perpendiculairement à la partie (40) de surface du substrat (4) à travers tout le substrat (4), qui est adjacente à la couche (3) et qui contient du matériau thermiquement isolant qui est adjacent verticalement à la couche (3),
**caractérisé en ce que**
- l'évidement (410) entoure de manière fermée annulairement, dans une direction (r3) parallèlement à la partie (40) de surface, une partie (44) du substrat s'étendant dans une direction (r2) perpendiculairement à la partie (40) de surface du substrat (4) et est isolé thermiquement du reste du substrat (4) et, ensemble avec la partie (44) isolée thermiquement du substrat (4), forme la région (42) du substrat isolée thermiquement se trouvant verticalement sous la région (35) chauffée de la couche (3).

2. Dispositif suivant la revendication 1, **caractérisé en ce que** la couche (3) est en SiO₂.

3. Dispositif suivant la revendication 1 ou 2, **caractérisé en ce que** le substrat (4) est en silicium.
